# EUROPÄISCHE PATENTANMELDUNG

(11) **EP 2 019 420 A1**
(43) Veröffentlichungstag der Anmeldung: **28.01.2009**
(21) Anmeldenummer: 08016611.9
(22) Anmeldetag: 22.04.2004
(51) Int. Cl.: H01L 21/306, H01L 21/00

(54) **Vorrichtung zum Texturieren von Oberflächen von Silizium-Scheiben und Verwendungen dieser Vorrichtung**

(30) Priorität: 07.05.2003 DE 10320212
(62) Teilanmeldung aus: 04728758.6
(71) Anmelder: Universität Konstanz, 78464 Konstanz (DE)
(72) Erfinder: Hauser, Alexander, 72351 Geislingen (DE); Melnyk, Ihor, Lwiw 79053 (UA); Fath, Peter, 78464 Konstanz (DE)
(74) Vertreter: RACKETTE Partnerschaft Patentanwälte

(57) **Zusammenfassung**

Bei einer Vorrichtung und Verwendungen dieser Vorrichtung ist eine Wanne (3) mit einer Ätzlösung (4) anteilig bestehend aus 20% bis 55% Wasser, 10% bis 40% Flusssäure mit einer Konzentration von wenigstens 50% und 20% bis 60% Salpetersäure mit einer Konzentration von wenigstens 65% vorhanden. Die Vorrichtung ist dazu eingerichtet ist, die Temperatur der Ätzlösung (4) zwischen etwa 0 Grad Celsius und etwa 15 Grad Celsius zu halten und die zu texturierenden Silizium-Scheiben (1) in die Ätzlösung (4) einzutauchen. Dadurch ergibt sich ein verhältnismäßig hoher Wirkungsgrad aufgrund verringerter Reflexionen der Silizium-Scheiben.

## Beschreibung

Die Erfindung betrifft eine Vorrichtung zum Texturieren von Oberflächen von Silizium-Scheiben gemäß dem Oberbegriff des Patentanspruches 1.

Die Erfindung betrifft weiterhin Verwendungen dieser Vorrichtung gemäß den Oberbegriffen der Patentansprüche 13, 14 und 17.

Aus dem Artikel "Isotropic Texturing of Multicrystalline Silicon Wafers with Acidic Texturing Solutions" von R. Einhaus, E. Vazsonyi, J. Szlufcik et al., erschienen in dem Tagungsband 26th PVSC, 30. September bis 3. Oktober 1997, Anaheim, Kalifornien, U.S.A., ist ein Verfahren bekannt, bei dem multikristalline Silizium-Scheiben in einer temperaturkontrollierten sauren Ätzlösung bestehend aus Wasser, Flusssäure mit einer Konzentration von 50% und Salpetersäure mit einer Konzentration von 70% an der Oberfläche texturiert werden, um den Wirkungsgrad beeinträchtigende Reflexionen zu verringern.

Aus den Dokumenten US-A-3,309,760, US 2002/0187583 A1, US-A-5,681,398 und US-A-5,174,855 sind Verfahren zum Behandeln von Oberflächen von Silizium-Scheiben bekannt, die dem Vorbereiten von Silizium vor einem Metallierungsschritt, dem Herausarbeiten einer Struktur beziehungsweise bei den letztgenannten Dokumenten der Reinigung dienen.

Der Erfindung liegt die Aufgabe zugrunde, eine Vorrichtung der eingangs genannten Art sowie Verwendungen dieser Vorrichtung der eingangs genannten Arten anzugeben, die insbesondere auch im industriellen Maßstab verhältnismäßig einfach einzusetzen sind und zu Silizium-Scheiben mit einem verbesserten Wirkungsgrad führen.

Diese Aufgabe wird bei einer Vorrichtung der eingangs genannten Art erfindungsgemäß mit den kennzeichnenden Merkmalen des Patentanspruches 1 gelöst.

Diese Aufgabe wird bei Verwendungen einer derartigen Vorrichtung der eingangs genannten Arten erfindungsgemäß mit den kennzeichnenden Merkmalen der Patentansprüche 13, 14 und 17 gelöst.

Durch die erfindungsgemäße Zusammensetzung der Ätzlösung anteilig aus 20% bis 55% Wasser, 10% bis 40% Flusssäure mit einer Konzentration von wenigstens 50% und 20% bis 60% Salpetersäure mit einer Konzentration von wenigstens 65% und zusätzlich dem Durchführen des Ätzvorganges bei der verhältnismäßig niedrigen, deutlich unter Raumtemperatur liegenden Ätzbadtemperatur wird eine merkliche Verbesserung des Wirkungsgrades erzielt. Weiterhin gestaltet sich zum einen das Ansetzen der Ätzlösung relativ unkritisch und läßt sich in verhältnismäßig kurzer Zeit durchführen. Zum anderen läßt sich der Ätzvorgang verhältnismäßig einfach kontrollieren.

Bei einer Weiterbildung der erfindungsgemäßen Vorrichtung besteht die Ätzlösung anteilig aus 30 % bis 40% Wasser, 15% bis 30% Flusssäure mit einer Konzentration von wenigstens 50% und 30% bis 50% Salpetersäure mit einer Konzentration von wenigstens 65%.

Bei einer weiteren Ausbildung der erfindungsgemäßen Vorrichtung liegt die Temperatur der Ätzlösung zwischen 7 Grad Celsius und 9 Grad Celsius.

Zweckmäßigerweise verbleiben bei einer erfindungsgemäßen Verwendung die Silizium-Scheiben zwischen 3 Minuten und 5 Minuten in der Ätzlösung.

Bei einem besonders bevorzugten Ausführungsbeispiel der erfindungsgemäßen Vorrichtung besteht die Ätzlösung anteilig aus 31% Wasser, 23% Flusssäure mit einer Konzentration von wenigstens 50% und 46% Salpetersäure mit einer Konzentration von wenigstens 65%, die Temperatur der Ätzlösung liegt bei 8 Grad Celsius, und bei einer erfindungsgemäßen Verwendung dieser beispielhaften erfindungsgemäßen Vorrichtung verbleiben die Silizium-Scheiben zwischen 1,5 Minuten und 2 Minuten in der Ätzlösung.

Bei einer Ausgestaltung der erfindungsgemäßen Vorrichtung sind die Silizium-Scheiben im wesentlichen vertikal ausgerichtet, und die Ätzlösung weist eine Strömungskomponente auf. Dadurch werden beide Oberflächen der Silizium-Scheiben im wesentlichen gleichartig texturiert.

Bei einer weiteren zweckmäßigen Ausgestaltung der erfindungsgemäßen Vorrichtung sind die Silizium-Scheiben im wesentlichen horizontal ausgerichtet, wobei die Ätzlösung ruht. Dadurch wird die nach oben weisende Oberfläche durch verhältnismäßig schnell wegperlende Gasbläschen besonders gut texturiert.

Bei einer weiteren, für die kontinuierliche Herstellung von Silizium-Scheiben besonders zweckmäßigen Weiterbildung der letztgenannten Ausgestaltung sind die Silizium-Scheiben durch die Ätzlösung bewegbar. Dadurch ergibt sich auf beiden Oberflächenseiten der Silizium-Scheiben besonders gute Texturierungen.

Zweckmäßigerweise sind die Silizium-Scheiben multikristallin. Weitere vorteilhafte Ausgestaltungen der Erfindung sind Gegenstand der nachfolgenden Beschreibung von bevorzugten Ausführungsbeispielen der Erfindung unter Bezug auf die Figuren der Zeichnung. Es zeigen:
- Fig. 1: in einer schematischen Darstellung die Anordnung von Silizium-Scheiben in einer erfindungsgemäßen Ätzlösung gemäß einem ersten Ausführungsbeispiel,
- Fig. 2: in einer schematischen Darstellung die Anordnung von Silizium-Scheiben in einer erfindungsgemäßen Ätzlösung gemäß einem zweiten Ausführungsbeispiel,
- Fig. 3: in einer schematischen Darstellung die Anordnung von Silizium-Scheiben in einer erfindungsgemäßen Ätzlösung gemäß einem dritten Ausführungsbeispiel,
- Fig. 4: in einem Schaubild die qualitative Abhängigkeit der mittle- ren Reflexion von der Ätzzeit bei einem Ätzvorgang mit ei- ner Ätzlösung bei Raumtemperatur und bei einem Ätzvor- gang mit einer erfindungsgemäßen Ätzlösung im erfin- dungsgemäßen Temperaturbereich,
- Fig. 5: in einem Schaubild die Abhängigkeit der Reflexion von der Wellenlänge bei einer in einer herkömmlichen sauren Ätz- lösung texturierten Silizium-Scheibe und einer erfindungs- gemäß texturierten Silizium-Scheibe und
- Fig. 6: eine mit einem Elektronenmikroskop gewonnene Dar- stellung einer Oberfläche einer erfindungsgemäß texturier- ten Silizium-Scheibe.

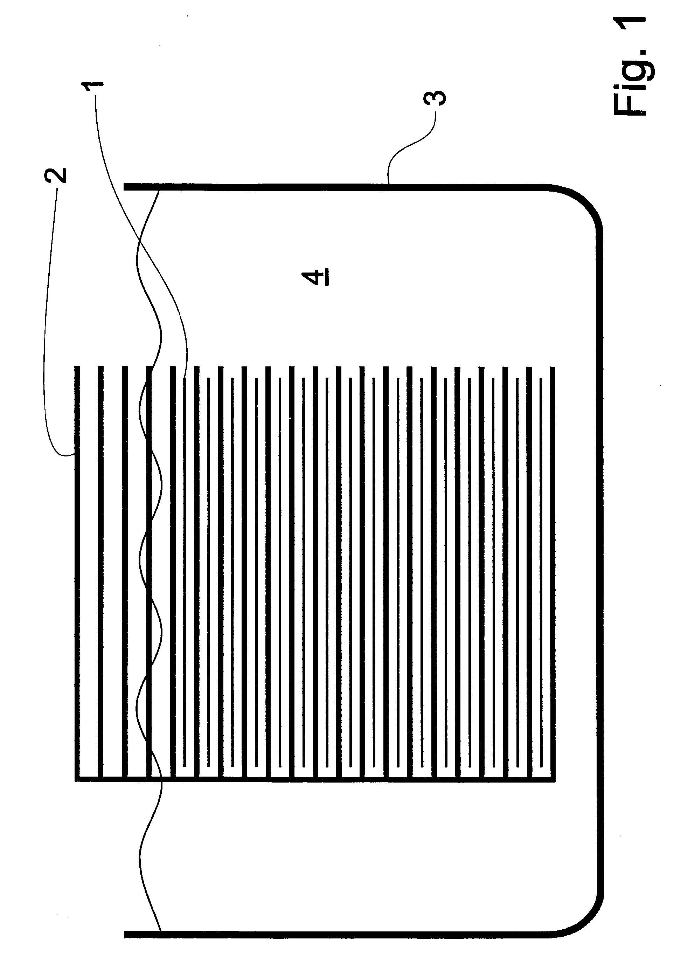

Fig. 1 zeigt in einer schematischen Darstellung eine Anzahl von als sogenannte Wafer ausgebildete multikristalline Silizium-Scheiben 1, die in an sich bekannter Weise mit einem Halter 2 verbunden sind. Der Halter 2 ist in der Darstellung gemäß Fig. 1 mit den Silizium-Scheiben 1 in horizontaler Ausrichtung in eine Wanne 3 eingetaucht die mit einer erfindungsgemäßen ruhenden Ätzlösung 4 gefüllt ist. Diese horizontale Anordnung führt dazu, dass Gasbläschen, die bei der Ätzvorgang an der nach oben weisenden Oberfläche der Silizium-Scheiben 1 entstehen, nach oben wegperlen und dadurch an der nach oben weisenden Oberfläche der Silizium-Scheiben 1 eine für das Verringern von Reflexionen sehr gute Texturierung erfolgt.

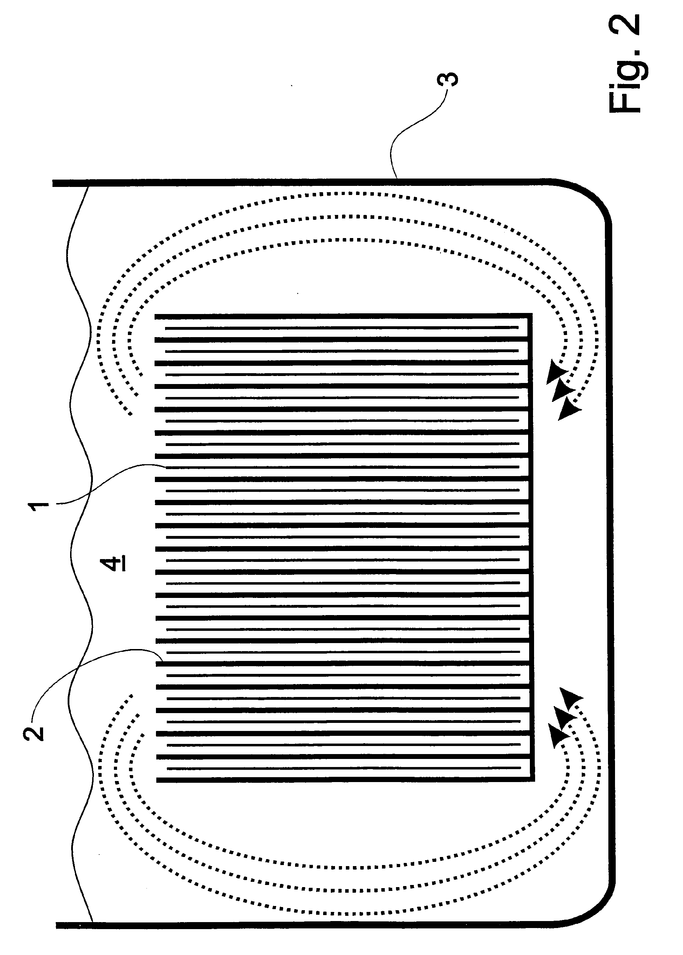

Fig. 2 zeigt in einer schematischen Darstellung die Anordnung von mit einem dem Ausführungsbeispiel gemäß Fig. 1 entsprechenden Halter 2 verbundenen Silizium-Scheiben 1 in einer erfindungsgemäßen Ätzlösung 4 gemäß einem zweiten Ausführungsbeispiel. Gemäß dem zweiten Ausführungsbeispiel sind die Silizium-Scheiben 1 vertikal angeordnet, wobei die Ätzlösung 4 beispielsweise durch Hin- und Herbewegen der Wanne 3 oder durch Einsatz eines in Fig. 2 nicht dargestellten, gegen starke Säuren beständigen Rührwerkzeuges die Ätzlösung 4 entlang der Silizium-Scheiben 1 eine durch gestrichelte Strömungslinien angedeutete Strömungskomponente aufweist. Dadurch wird erreicht, dass sich während des Ätzvorganges an beiden Oberflächen der Silizium-Scheiben 1 ausbildende Gasbläschen frühzeitig ablösen und nach oben wegperlen, so dass beide Oberflächenseiten der Silizium-Scheiben 1 gleichmäßig texturiert werden.

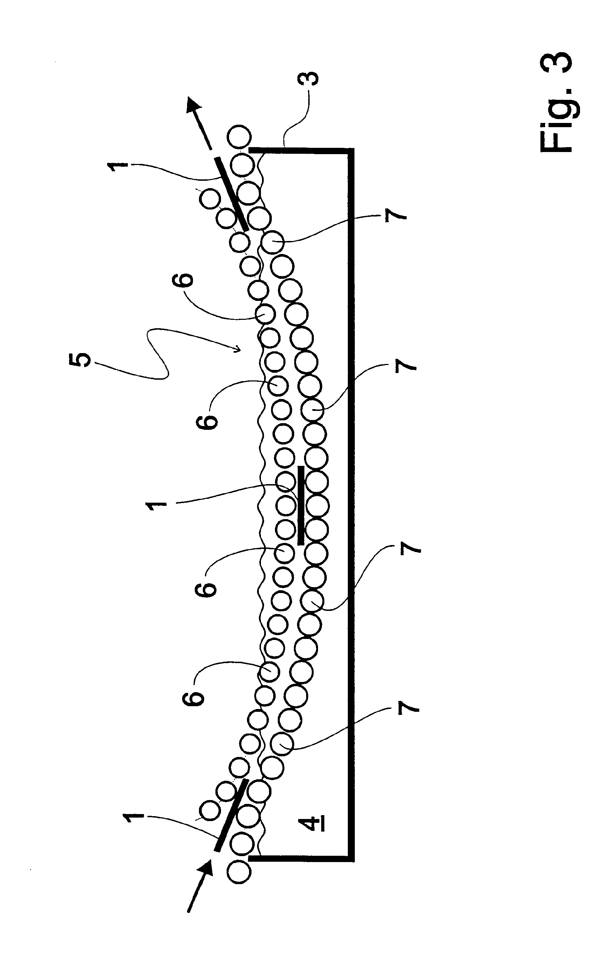

Fig. 3 zeigt in einer schematischen Darstellung die Anordnung von Silizium-Scheiben 1 in einer erfindungsgemäßen Ätzlösung 4 gemäß einem dritten Ausführungsbeispiel. Bei dem Ausführungsbeispiel gemäß Fig. 3 ist eine Rollenbahn 5 mit einer Anzahl von in einem Abstand einander gegenüberliegenden, wenigstens teilweise angetriebenen oberen Rollen 6 und unteren Rollen 7 vorhanden, mit der die zu texturierenden Silizium-Scheiben 1 in einer im wesentlichen horizontalen Bahn durch die in der Wanne 3 vorgehaltene erfindungsgemäße Ätzlösung 4 durchgeführt werden. Dieses Ausführungsbeispiel zeichnet sich dadurch aus, dass es bei sehr gute Texturierung beider Oberflächenseiten für die kontinuierliche Produktion von Silizium-Scheiben 1 besonders gut einsetzbar ist.

Die Zusammensetzung einer beispielhaften erfindungsgemäßen Ätzlösung 4 aus Wasser, konzentrierter Flusssäure, das heißt mit einer Konzentration von wenigstens etwa 50%, und konzentrierter Salpetersäure, das heißt mit einer Konzentration von wenigstens etwa 65%, ist wie folgt, wobei bei anderen Konzentrationen der Flusssäure und der Salpetersäure die Anteile entsprechend anzupassen sind:

| | |
|---|---|
| 2 | Anteile Wasser (H₂O), |
| 1,5 | Anteile Flusssäure (HF, Konzentration 50%) und |
| 3 | Anteile Salpetersäure (HNO₃ Konzentration 65%). |

Bei den Ausführungsbeispielen gemäß Fig. 1 bis Fig. 3 wird die Temperatur der Ätzlösung 4 erfindungsgemäß zwischen etwa 0 Grad Celsius und etwa 15 Grad Celsius, bevorzugt zwischen etwa 7 Grad Celsius und etwa 9 Grad Celsius, gehalten.

Damit ergibt sich bei einer unverbrauchten Ätzlösung 4 beim Texturieren eine Anwendungsdauer zu Beginn von etwa 3 Minuten, die sich nach dem Texturieren von 550 Silizium-Scheiben 1 mit einer Größe von 12,5 x 12,5 cm² in etwa 12 Liter Ätzlösung 4 auf etwa 5 Minuten verlängert.

Bei einem besonders bevorzugten Ausführungsbeispiel werden
4 Anteile Wasser (H₂O),
3 Anteile Flusssäure (HF, Konzentration 50%) und
6 Anteile Salpetersäure (HNO₃, Konzentration 65%).
verwendet, wobei die Temperatur der Ätzlösung 4 bei etwa 8 Grad Celsius gehalten wird. Die Anwendungsdauer liegt bei diesem besonders bevorzugten Ausführungsbeispiel zwischen 1,5 Minuten und 2 Minuten.

Der Ätzvorgang wird durch Wiegen texturierter Silizium-Scheiben 1 vor und nach der Ätzvorgang kontrolliert, wobei in Abhängigkeit der Größe der jeweiligen Silizium-Scheibe 1 und des gewünschten Ätzabtrags ein bestimmter Soll-Gewichtsverlust die korrekte Dauer des Ätzvorganges anzeigt. Liegt der Ist-Gewichtsverlust unter dem Soll-Gewichtsverlust, wird die Dauer des Ätzvorganges solange erhöht, bis der Ist-Gewichtsverlust mit dem Soll-Gewichtsverlust übereinstimmt. Liegt entsprechend der Ist-Gewichtsverlust über dem Soll-Gewichtsverlust, wird die Dauer des Ätzvorganges solange verkürzt, bis der Ist-Gewichtsverlust mit dem Soll-Gewichtsverlust übereinstimmt.

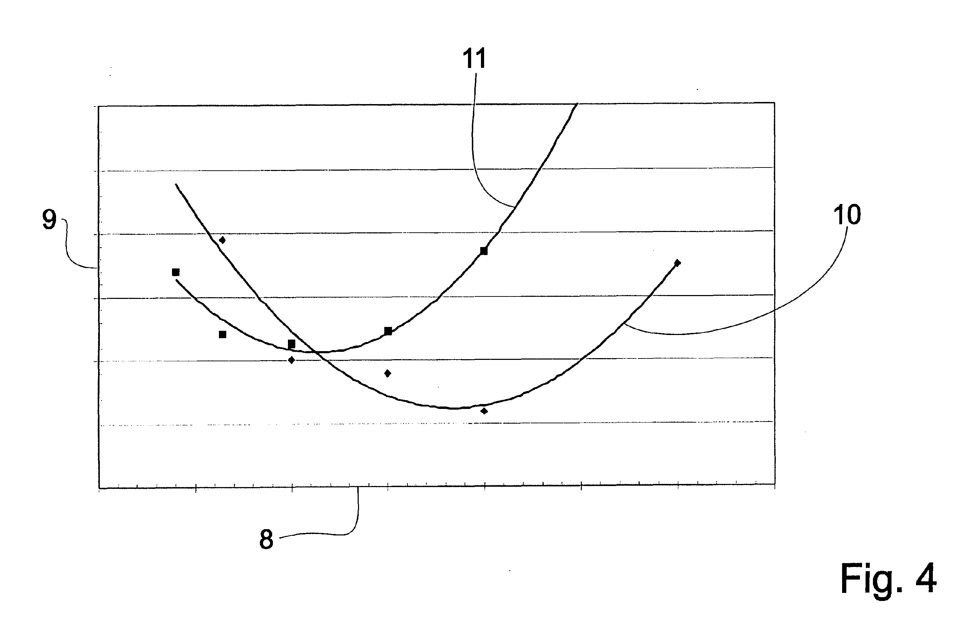

Fig. 4 in einem Schaubild die qualitative Abhängigkeit der mittleren Reflexion von der Ätzzeit bei einem Vergleichsverfahren mit einer Ätzlösung bei Raumtemperatur und bei einem Ätzvorgang mit einer erfindungsgemäßen Ätzlösung im erfindungsgemäßen Temperaturbereich.

In dem Schaubild gemäß ist Fig. 4 auf der Abszisse 8 ist die Ätzzeit abgetragen. Auf der Ordinaten 9 ist die über einen Wellenlängenbereich von 400 Nanometer bis 1100 Nanometer gemittelte mittlere Reflexion abgetragen. Die durch eine erste Näherungskurve 10 approximierten Werte stammen von erfindungsgemäß texturierten Silizium-Scheiben 1. Die durch eine zweite Näherungskurve 11 approximierten Messwerte stammen von mit einem Vergleichsverfahren texturierten Silizium-Scheiben.

Der Vergleich der ersten Näherungskurve 10 für die Erfindung mit der zweiten Näherungskurve für das Vergleichsverfahren zeigt, dass die mittlere Reflexion bei erfindungsgemäß texturierten Silizium-Scheiben 1 merklich niedriger ist als bei den mit dem Vergleichsverfahren texturierten Silizium-Scheiben.

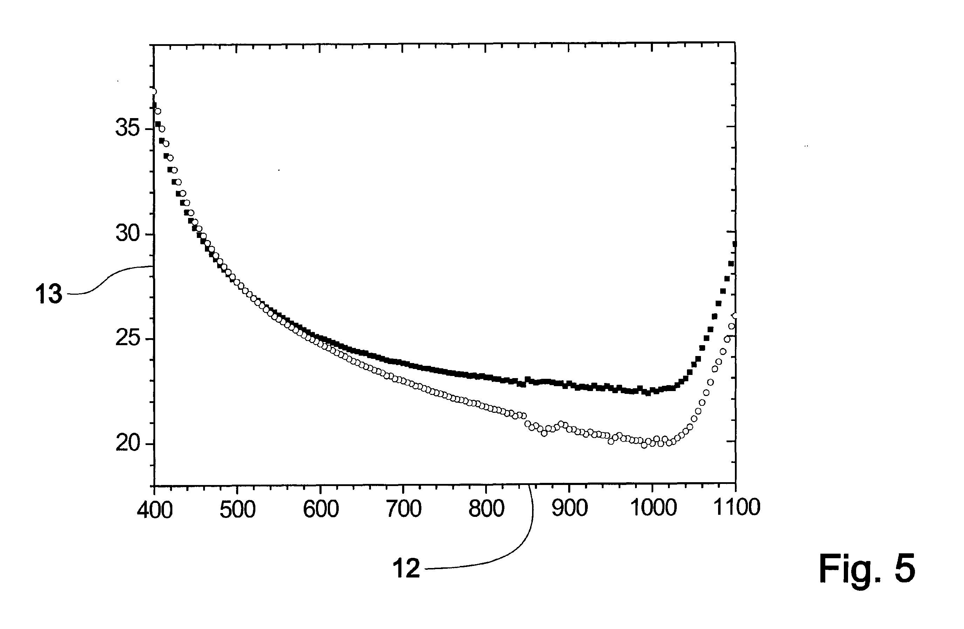

Fig. 5 zeigt in einem Schaubild die Abhängigkeit der Reflexion von der Wellenlänge bei einer in einer herkömmlichen sauren Ätzlösung texturierten Silizium-Scheibe und einer erfindungsgemäß texturierten Silizium-Scheibe 1.

In dem Schaubild gemäß Fig. 5 ist auf der Abszissen 12 die Wellenlänge in Nanometer und auf der Ordinaten 13 die Reflexion in Prozent abgetragen. Die nicht ausgefüllten Kreise stehen für Messwerte bei erfindungsgemäß mit der oben angegebenen beispielhaften Ätzlösung 4 texturierten Silizium-Scheiben 1, während die mit ausgefüllten Quadraten repräsentierten Messwerte für ein herkömmliches, von IMEC entwickelten Verfahren (nachfolgend 'IMEC-VergleichsverfahrenA genannt) nach dem Artikel "Torwards Highly Efficient Industrial Cells and Modules from Multicrystalline Wafers" von F. Duerinckx, L. Frisson, P.P. Michiels et al., erschienen bei 17th European Photovoltaic Solar Energy Conference, 22. bis 26. Oktober 2001, München, Deutschland, stehen.

Bei dem IMEC-Vergleichsverfahren weist die Ätzlösung HF, HNO₃ sowie einige Additive auf. Die Temperatur der Ätzlösung beträgt 21 Grad Celsius. Die Silizium-Scheiben verbleiben 3 Minuten in der Ätzlösung.

Dem Schaubild gemäß Fig. 5 ist zu entnehmen, dass sich bei erfindungsgemäß texturierten Silizium-Scheiben 1 mit einer mittleren Reflexion von 23,8% insbesondere ab einer Wellenlänge von etwa 600 Nanometer um bis zu etwa 2,5% niedrigere Reflexionswerte als bei gemäß dem IMEC-Vergleichsverfahren texturierten Silizium-Scheiben mit einer mittleren Reflexion von 24,9% ergeben.

In der nachfolgenden Tabelle sind wichtige Kenngrößen für erfindungsgemäß texturierten Silizium-Scheiben 1 (UKN-Isotextur) und gemäß dem IMEC-Vergleichsverfahren texturierten Silizium-Scheiben (IMEC-Isotextur) jeweils im Vergleich mit einer Texturieren mit einer basischen NaOH-Lösung gegenübergestellt.

| | UKN-Isotextur | | | | IMEC-Isotextur | | | |
|---|---|---|---|---|---|---|---|---|
| | FF | J_{SC} | V_{OC} | Eta | FF | J_{SC} | V_{OC} | Eta |
| | % | mA/cm² | mV | % | % | mA/cm² | mV | % |
| NaOH | 76,3 | 31,2 | 615,9 | 14,6 | 77,9 | 30,5 | 620 | 14,8 |
| Isotextur | 76,6 | 33,2 | 614,1 | 15,6 | 77,9 | 31,6 | 614 | 15,2 |
| Verbesserung relativ [%] | 0,4 | 5,4 | -0,3 | 6,8 | 0 | 3,6 | -1 | 2,7 |

Für die IMEC-Isotextur sind die Daten aus Duerinckx et al. abgeleitet.

Dabei bedeuten für die jeweiligen Silizium-Scheiben:
- FF:: Füllfaktor,
- J_{SC}:: Kurzschlussstromdichte,
- V_{OC}:: offene Klemmenspannung und
- Eta :: Wirkungsgrad.

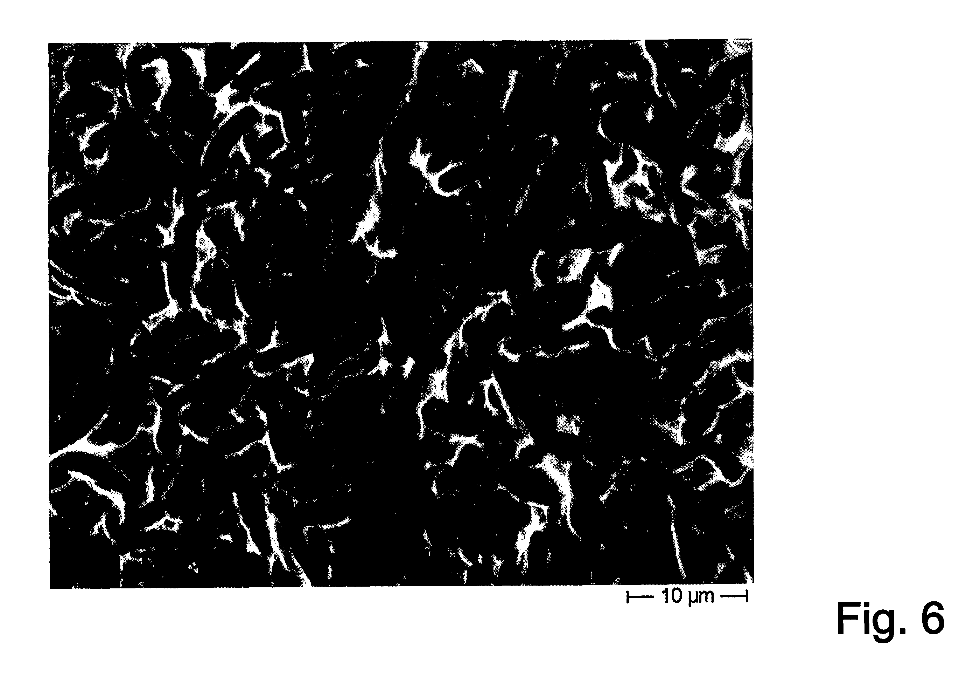

Fig. 6 zeigt eine vergrößerte fotografische Darstellung einer Oberfläche einer erfindungsgemäß texturierten Silizium-Scheibe 1 mit einer Skalierungsangabe. Aus Fig. 6 ist ersichtlich, dass die Texturierung gemäß der Erfindung zu zum Teil verhältnismäßig langgestreckten bandartigen Vertiefungen führt, in eine ausgeprägte reflexionsmindernde Strukturierung der Oberfläche hervorrufen.

Es versteht sich, dass erfindungsgemäß auch monokristalline Silizium-Scheiben oder direkt aus der Schmelze gezogene Silizium-Scheiben, sogenanntes Foliensilizium, texturierbar sind.

## Patentansprüche

1. Vorrichtung zum Texturieren von Oberflächen von Silizium-Scheiben (1), die eine Wanne (3) mit einer Ätzlösung (4) anteilig bestehend aus 20% bis 55% Wasser, 10% bis 40% Flusssäure mit einer Konzentration von wenigstens 50% und 20% bis 60% Salpetersäure mit einer Konzentration von wenigstens 65% aufweist, wobei die Vorrichtung dazu eingerichtet ist, die Temperatur der Ätzlösung (4) zwischen etwa 0 Grad Celsius und etwa 15 Grad Celsius zu halten und die zu texturierenden Silizium-Scheiben (1) in die Ätzlösung (4) einzutauchen.

2. Vorrichtung nach Anspruch 1, **dadurch gekennzeichnet, dass** die Vorrichtung dazu eingerichtet ist, die Temperatur der Ätzlösung (4) zwischen etwa 7 Grad Celsius und etwa 9 Grad Celsius zu halten.

3. Vorrichtung nach Anspruch 1 oder Anspruch 2, **dadurch gekennzeichnet, dass** ein zur Aufnahme der zu texturierenden Silizium-Scheiben (1) eingerichteter Halter (2) vorhanden ist.

4. Vorrichtung nach Anspruch 3, **dadurch gekennzeichnet, dass** der Halter (2) dazu eingerichtet ist, die zu texturierenden Silizium-Scheiben (1) in horizontaler Ausrichtung zu halten.

5. Vorrichtung nach Anspruch 3, **dadurch gekennzeichnet, dass** der Halter (2) dazu eingerichtet ist, die zu texturierenden Silizium-Scheiben (1) in vertikaler Ausrichtung zu halten.

6. Vorrichtung nach einem der Ansprüche 1 bis 5, **dadurch gekennzeichnet, dass** eine Rollenbahn (5) zum Durchführen der zu texturierenden Silizium-Scheiben (1) durch die Ätzlösung (4) vorhanden ist.

7. Vorrichtung nach Anspruch 6, **dadurch gekennzeichnet, dass** die Rollenbahn (5) dazu eingerichtet ist, die zu texturierenden Silizium-Scheiben (1) in einer im wesentlichen horizontalen Bahn durch die Ätzlösung (4) zu führen.

8. Vorrichtung nach Anspruch 6 oder Anspruch 7, **dadurch gekennzeichnet, dass** die Rollenbahn (5) eine Anzahl von in einem Abstand einander gegenüberliegenden, wenigstens teilweise angetriebenen oberen Rollen (6) und unteren Rollen (7) aufweist.

9. Vorrichtung nach einem der vorangegangenen Ansprüche, welche für ein Hin- und Herbewegen der Wanne (3) eingerichtet ist.

10. Vorrichtung nach einem der vorangegangenen Ansprüche, **dadurch gekennzeichnet, dass** ein Rührwerkzeug zum Erzeugen einer Strömung einer in der Wanne (3) aufgenommenen Ätzlösung (4) entlang der zu texturierenden Silizium-Scheiben (1) vorhanden ist.

11. Vorrichtung nach einem der Ansprüche 1 bis 10, **dadurch gekennzeichnet, dass** die Ätzlösung (4) anteilig aus 30% bis 40% Wasser, 15% bis 30% Flusssäure mit einer Konzentration von wenigstens 50% und 30% bis 50% Salpetersäure mit einer Konzentration von wenigstens 65% besteht.

12. Vorrichtung nach einem der Ansprüche 1 bis 10, **dadurch gekennzeichnet, dass** die Ätzlösung (4) anteilig aus 31% Wasser, 23% Flusssäure mit einer Konzentration von wenigstens 50% und 46% Salpetersäure mit einer Konzentration von wenigstens 65% besteht, dass die Temperatur der Ätzlösung (4) bei 8 Grad Celsius liegt.

13. Verwendung einer Vorrichtung nach einem der Ansprüche 1 bis 10, die dazu eingerichtet ist, ein Verfahren zum Texturieren von Oberflächen von Silizium-Scheiben (1) auszuführen mit den Schritten des Eintauchens der Silizium-Scheiben (1) in einer Ätzlösung aus Wasser, Flusssäure mit einer Konzentration von wenigstens 50% und Salpetersäure mit einer Konzentration von wenigstens 65% und des Einstellens einer Temperatur für die Ätzlösung, **dadurch gekennzeichnet, dass** die Ätzlösung (4) anteilig aus 20% bis 55% Wasser, 10% bis 40% Flusssäure mit einer Konzentration von wenigstens 50% und 20% bis 60% Salpetersäure mit einer Konzentration von wenigstens 65% besteht und dass die Temperatur der Ätzlösung (4) zwischen 0 Grad Celsius und 15 Grad Celsius liegt.

14. Verwendung einer Vorrichtung nach Anspruch 11, die dazu eingerichtet ist, ein Verfahren zum Texturieren von Oberflächen von Silizium-Scheiben (1) auszuführen mit den Schritten des Eintauchens der Silizium-Scheiben (1) in einer Ätzlösung aus Wasser, Flusssäure mit einer Konzentration von wenigstens 50% und Salpetersäure mit einer Konzentration von wenigstens 65% und des Einstellens einer Temperatur für die Ätzlösung, **dadurch gekennzeichnet, dass** die Ätzlösung (4) anteilig aus 30% bis 40% Wasser, 15% bis 30% Flusssäure mit einer Konzentration von wenigstens 50% und 30% bis 50% Salpetersäure mit einer Konzentration von wenigstens 65% besteht und dass die Temperatur der Ätzlösung (4) zwischen 0 Grad Celsius und 15 Grad Celsius liegt.

15. Verwendung einer Vorrichtung nach Anspruch 13 oder 14, **dadurch gekennzeichnet, dass** die Temperatur der Ätzlösung (4) zwischen 7 Grad Celsius und 9 Grad Celsius liegt.

16. Verwendung einer Vorrichtung nach einem der Ansprüche 13 bis 15, wobei die Silizium-Scheiben (1) zwischen 3 Minuten und 5 Minuten in der Ätzlösung (4) verbleiben.

17. Verwendung einer Vorrichtung nach Anspruch 12, die dazu eingerichtet ist, ein Verfahren zum Texturieren von Oberflächen von Silizium-Scheiben (1) auszuführen mit den Schritten des Eintauchens der Silizium-Scheiben (1) in einer Ätzlösung aus Wasser, Flusssäure mit einer Konzentration von wenigstens 50% und Salpetersäure mit einer Konzentration von wenigstens 65% und des Einstellens einer Temperatur für die Ätzlösung, **dadurch gekennzeichnet, dass** die Ätzlösung (4) anteilig aus 31% Wasser, 23% Flusssäure mit einer Konzentration von wenigstens 50% und 46% Salpetersäure mit einer Konzentration von wenigstens 65% besteht, dass die Temperatur der Ätzlösung (4) bei 8 Grad Celsius liegt und dass die Silizium-Scheiben (1) zwischen 1,5 Minuten und 2 Minuten in der Ätzlösung (4) verbleiben.
